# EUROPÄISCHE PATENTANMELDUNG

(11) **EP 1 952 929 A1**
(43) Veröffentlichungstag der Anmeldung: **06.08.2008**
(21) Anmeldenummer: 08001064.8
(22) Anmeldetag: 21.01.2008
(51) Int. Cl.: B23K 1/008

(54) **Verfahren zum Reflow-Löten**

(30) Priorität: 02.02.2007 DE 102007005345
(71) Anmelder: Seho Systemtechnik GmbH, 97892 Kreuzwertheim (DE)
(72) Erfinder: Diehm, Rolf, 97877 Wertheim (DE); Walter, Markus, 97877 Wertheim (DE); Lettner, Horst, 63739 Aschaffenburg (DE)
(74) Vertreter: Bardehle, Heinz

(57) **Zusammenfassung**

Die Erfindung betrifft ein Verfahren zum Reflow-Löten von mit Lötpaste versehenen Baugruppen (15) in einer abgeschotteten Kammer (19) unter Beheizung in der Kammer. In einem ersten Verfahrensschritt wird der Druck in der Kammer gegenüber dem atmosphärischen Druck verstärkt und die Temperatur in der Kammer durch Konvektionsheizung zum Schmelzen der Lötpaste erhöht und in einem zweiten Verfahrensschritt wird der Druck gesteuert auf atmosphärischen Druck unter Aufrechterhaltung der Temperatur wieder abgesenkt.

## Beschreibung

Die Erfindung bezieht sich auf ein Verfahren zum Reflow-Löten von mit Lötpaste versehenen Baugruppen in einer abgeschotteten Kammer unter Beheizung in der Kammer.

Beim Reflow-Löten entstehen gelegentlich in den Lötstellen Lunker, sog. Voids, die einerseits den elektrisch wirksamen Querschnitt der betreffenden Lötstelle verringern und andererseits die Gefahr eines Aufbrechens der Lötstelle mit sich bringen. Auf jeden Fall bilden solche Lunker auch wegen schlechterer Abführung von in den Baugruppen entstehender Verlustwärme eine Gefährdung der betreffenden Baugruppe, so dass bereits Überlegungen angestellt worden sind, entstandene Lunker noch während des Lötprozesses wieder zu beseitigen. Dabei ist man bisher so vorgegangen, dass die durch Reflow-Löten vervollständigten Baugruppen in einer durch Schleusen abgeschotteten Kammer während des Lötprozesses einem Vakuum bzw. einem erheblichen Unterdruck ausgesetzt werden, wodurch das in einem Lunker enthaltene Gas gewissermaßen aus dem Lunker, der dabei aufplatzt, abgesogen wird, womit dann eine ununterbrochene Lötstelle entsteht.

Dieser Vorgang des Evakuierens erfordert in einem kontinuierlichen Fabrikationsprozess einen erheblichen Zeitaufwand, da ein für den betreffenden Zweck notwendiger Unterdruck sich nicht schlagartig herstellen lässt. Hierfür ist in jedem Falle ein aufwendiger Abpumpvorgang erforderlich, der nicht mit großer Schnelligkeit durchgeführt werden kann und in der Regel, wie die Erfahrung zeigt, mehrere Sekunden dauert. Außerdem lässt das Evakuieren der abgeschotteten Kammer nicht alle üblichen Erwärmungsmethoden zu, da wegen des Vakuums auf jeden Fall Konvektionsheizung ausscheidet. Es wird daher im Zusammenhang mit der durch Evakuierung bewirkten Beseitigung von Lunkern meist die Temperaturerhöhung in der Kammer durch Kondensation einer inerten Flüssigkeit mit einem Siedepunkt geringfügig oberhalb des Schmelzpunktes des Lots in einer Dampfphase herbeigeführt. Als Beispiel für diesen Stand der Technik sei auf die DE 102 37 494 A1 verwiesen. Den gleichen Verfahrensablauf beschreibt die DE 199 11 887 C1.

Der Erfindung liegt die Aufgabe zugrunde, Lunkern in Lötstellen von durch Reflow-Löten gebildeten Baugruppen in einer Weise entgegen zu wirken, dass dabei einerseits nur ein geringer technischer Aufwand erforderlich ist und andererseits eine besondere Schnelligkeit bei der Beseitigung von entstandenen Lunkern erzielbar ist. Erfindungsgemäß geschieht dies dadurch, dass in einem ersten Verfahrensschritt der Druck in der Kammer gegenüber dem atmosphärischen Druck verstärkt und die Temperatur in der Kammer durch Konvektionsheizung zum Schmelzen der Lötpaste erhöht wird und in einem zweiten Verfahrensschritt der Druck gesteuert auf atmosphärischen Druck unter Aufrechterhaltung der Temperatur wieder abgesenkt wird.

Die in dem ersten Verfahrensschritt kombinierten Vorgänge der Verstärkung des Druckes in der Kammer und der Erhöhung der Temperatur in der Kammer durch Konvektionsheizung lassen sich mit relativ einfachen technischen Mitteln herbeiführen. Für die Druckerhöhung stehen z.B. kostengünstige Gasdruckflaschen zur Verfügung, aus denen Gas, insbesondere Luft, unter hohem Druck in die Kammer eingeleitet werden kann. Dabei kommt es auch auf eine besonders sichere Abdichtung der Kammer nicht entscheidend an, da man es sich bei diesem Verfahren ohne weiteres leisten kann, dass von einer Gasdruckflasche abgezweigtes Gas über Undichtigkeiten in den die Kammer eingrenzenden Schleusen entweicht. Demgegenüber führt bei der Herstellung eines Vakuums jede Undichtigkeit an den Schleusen zu einer erheblichen Verzögerung des Abpumpens von Gas aus der Kammer. Damit werden also die Schleusen, durch die die Kammer abgeschottet wird, technisch im Falle der Verstärkung des Drucks in der Kammer wesentlich vereinfacht. Darüber hinaus lässt die Druckverstärkung auch die besonders günstig wirkende Konvektionsheizung in der Kammer zu, da hierfür das notwendige Gas in der Kammer zur Verfügung steht, das durch Umwälzen alle Teile einer Baugruppe leicht erreichen kann. Bei der Absenkung des atmosphärischen Drucks unter Aufrechterhaltung der Temperatur in der Kammer ergibt sich dann aus dem Inneren von gegebenenfalls vorhandenen Lunkern in diesen ein Überdruck, der von der vorhergehenden Druckerhöhung stammt, womit die Lunker gegenüber dem abgesenkten Druck in der Kammer aufplatzen und das in ihnen enthaltene Gas freisetzen, wobei die Temperatur in der Kammer oberhalb des Schmelzens der Lötpaste aufrecht erhalten bleibt und die geöffneten Lunker verschwinden.

Das erfindungsgemäße Verfahren stellt also eine grundsätzliche Abkehr von dem bekannten Verfahren der Anwendung eines Vakuums dar, was sich auch darin bestätigt, dass bereits im ersten Verfahrensschritt, bei dem die Temperatur in der Kammer durch Konvektionsheizung zum Schmelzen der Lötpaste erhöht wird, der Druck in der Kammer gegenüber dem atmosphärischen Druck verstärkt wird, womit also bei erschmolzenem Lot in gegebenenfalls vorhandenen Lunkern gegenüber dem atmosphärischen Druck ein Überdruck aufgebaut wird. Dieser Überdruck entweicht dann erst während des zweiten Verfahrensschritts bei der Absenkung des Drucks in der Kammer, und zwar unter Aufrechterhaltung der Temperatur des Lötguts, damit dieses in erschmolzenem Zustand den gegebenenfalls vorhandenen Überdruck in den Lunkern entweichen lassen kann. Dieses Entweichen eines Überdrucks findet sofort mit dem Erschmelzen des Lötgutes statt, was ebenfalls die Unterschiedlichkeit des bekannten Verfahrens gegenüber dem erfindungsgemäßen Verfahren verdeutlicht.

Eine Intensivierung der Auswirkung der Druckänderung auf evtl. Lunker lässt sich vorteilhaft dadurch erzielen, dass man entweder der Druckverstärkung oder der Druckabsenkung eine abwechselnde Druckänderung überlagert. Dabei ist es auch möglich, diese Überlagerung durch die abwechselnde Druckänderung nicht nur in der einen Richtung, nämlich entweder Druckverstärkung oder Druckabsenkung, vorzunehmen, sondern die Überlagerung in beiden Richtungen vorzusehen, also innerhalb des erfindungsgemäßen Verfahrens bei der erfolgenden Verlötung sowohl die Druckverstärkung als auch die Druckabsenkung mit der überlagernden abwechselnden Druckänderung zu gestalten. Das dabei sich ergebende Pulsieren erleichtert es evtl. Lunkern aufzuplatzen und das in ihnen enthaltene Gas abzugeben, womit die Lunker mit Sicherheit gänzlich zum Verschwinden gebracht werden können.

In den Figuren sind Ausführungsbeispiele der Erfindung dargestellt. Es zeigen:
- Figur 1: eine Vorrichtung zum Reflow-Löten mit einer mittleren Lötstufe zur Behandlung der Baugruppen unter Überdruck;
- Figur 2: die gleiche Vorrichtung mit einer Gestaltung der mittleren Lötstufe zur Absenkung und Anhebung eines Druckgehäuses;
- Figuren 3a, b, c, d: die einzelnen Phasen des Aufschmelzens des Lots und der Lunkerbeseitigung in den Lötstellen, dabei zeigen

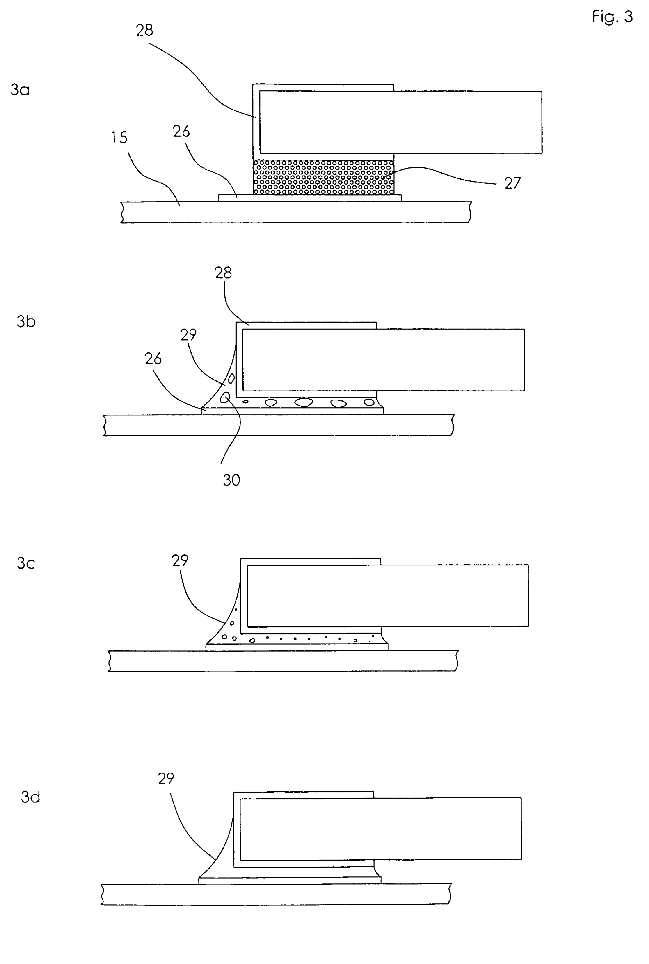

- Figur 3a: die mit Lötpaste versehen Lötstelle im ungelöteten Zustand;
- Figur 3b: die Lunker enthaltende aufgeschmolzene Lötstelle;
- Figur 3c: die gleiche Lötstelle unter der Wirkung des Überdrucks mit stark eingeengten Lunkern;
- Figur 3d: die gleiche Lötstelle ohne Lunker;

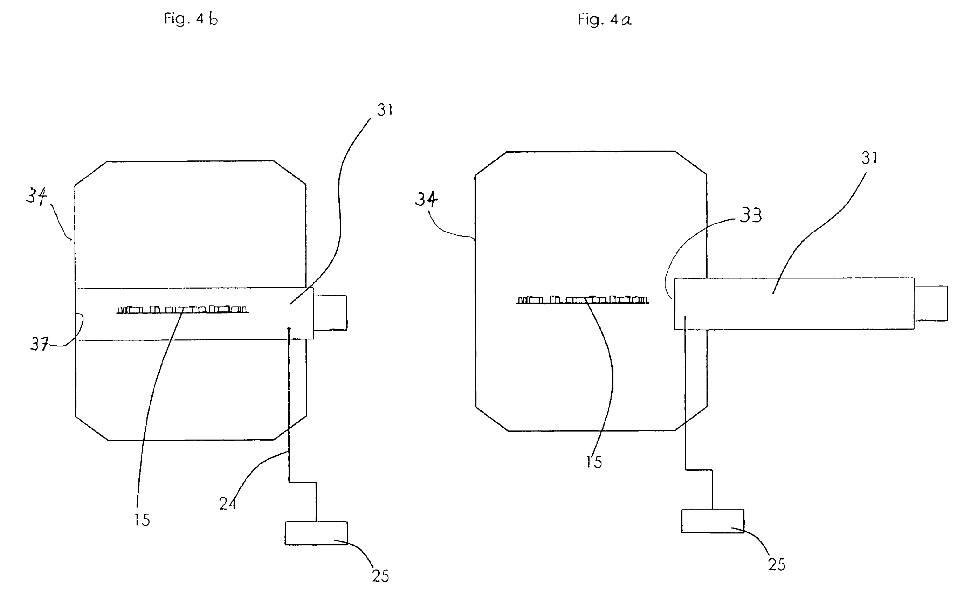

- Figur 4a, b: eine Seitensicht der mittleren Stufe, bei der das Druckgehäuse von der Seite her ein- und ausgeschoben wird.

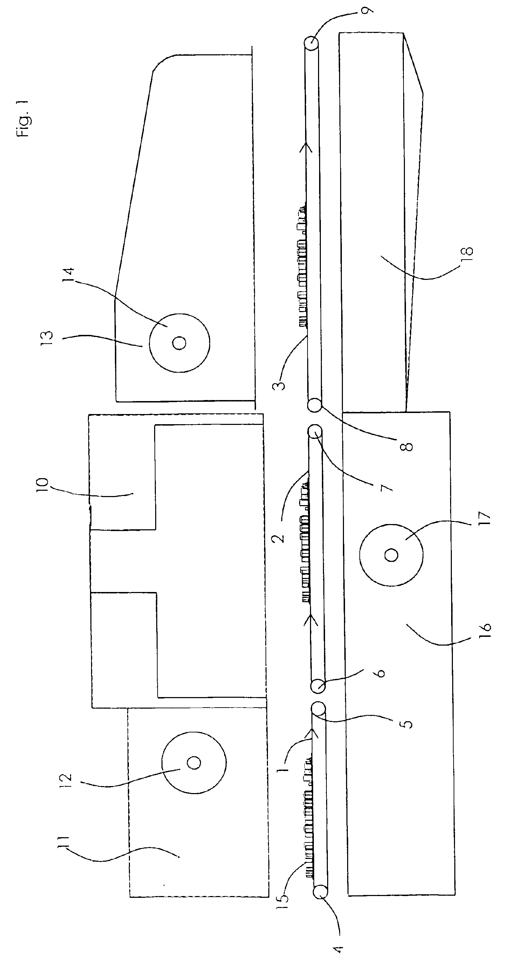

Die in der Figur 1 dargestelle Anlage zum Reflow-Löten von Baugruppen 15 enthält als Transportmechanismus mehrere aufeinander folgende Transportbänder 1, 2 und 3, die im Bedarfsfalle nach beiden Seiten hin noch durch weitere einzelne Transportbänder ergänzt werden können. Bei den Transportbändern handelt es sich in bekannter Weise um Kettengliedergurte, die um Transportrollen 4, 5, 6, 7, 8 und 9 geschlungen sind und von diesen Transportrollen in der eingezeichneten Pfeilrichtung angetrieben werden. In der Mitte der Vorrichtung befindet sich die dem Verlöten dienende Lötstufe 10, auf deren Funktion weiter unten näher eingegangen wird. Der Lötstufe 10 ist die Heizstufe 11 vorgeordnet, die zum Aufschmelzen der Lötstellen in bekannter Weise aufgeheizt werden kann, z. B. mit einem Heizlüfter 12. Der Lötstufe 10 ist die Kühlstufe 13 nachgeordnet, die ebenfalls mit einem Lüfter 14 versehen ist, um den Baugruppen 15 kühle Luft zuzuführen. Gemäß Figur 1 sind mehrere Baugruppen 15 auf den Transportbändern 1, 2 und 3 dargestellt, wodurch dargestellt werden soll, dass die Anlage im Prinzip kontinuierlich arbeitet. Unterhalb der Transportbänder 1, 2 und 3 ist die Unterkassette 16 mit dem Heizlüfter 17 und die Kühlkassette 18 angeordnet.

Bei der vorstehend erläuterten Anlage handelt es sich im Prinzip um eine bekannte Anordnung, wie diese in der DE 10 2004 017 772 A1 dargestellt und erläutert ist.

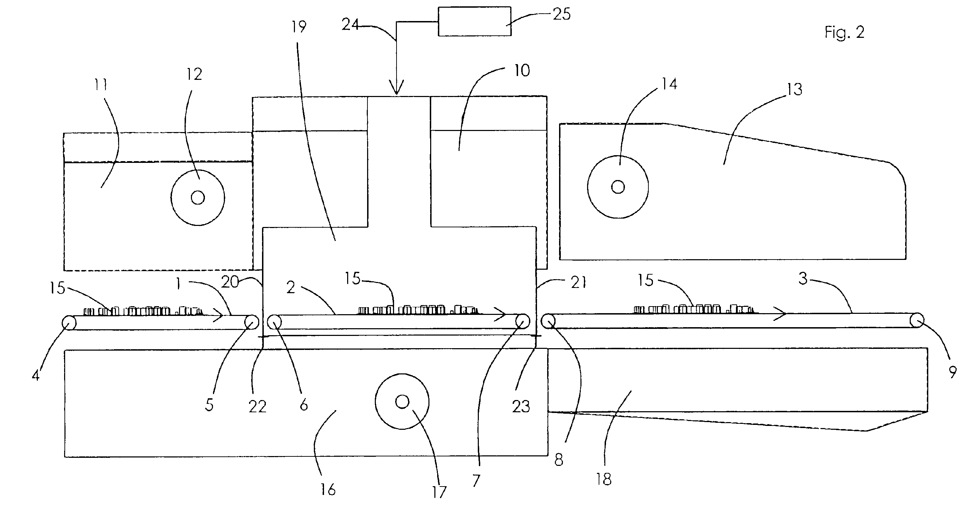

In der Figur 2 ist die Vorrichtung gemäß Figur 1 in der Arbeitslage dargestellt, in der in der Lötstufe 10 das Druckgehäuse 19 abgesenkt ist und dabei mit seinen Wänden 20 und 21 auf die abdichtenden Gegenlager 22 und 23 unterhalb des Transportbandes 2 trifft. Damit befindet sich das Transportband 2 in einer abgeschotteten Kammer, die über die Druckgasleitung 24 mit Druckgas versorgt wird, das von der Pumpe 25 in die Druckgasleitung 24 gepumpt wird. Dabei bildet sich in der durch den Innenraum des Druckgehäuses 19 gebildeten Kammer ein über dem atmosphärischen Druck liegender Druck aus, der sich auch auf die mit Lötpaste versehene Baugruppe 15 auswirkt, und zwar in der Weise, wie dies anhand der Figuren 3a - 3d dargestellt ist, worauf weiter unten näher eingegangen wird. Die an den Lötstellen der Baugruppe 15 befindliche Lötpaste war dabei aufgeschmolzen und hat die ggf. entstehenden Lunker eingeschlossen.

Nach erfolgter Verlötung wird der Druck in dem Druckgehäuse 19 wieder auf atmosphärischen Druck abgesenkt und die Baugruppe 15 vom Transportband 2 auf das Transportband 3 weiter befördert, wo es dann aufgrund der Wirkung des Kühllüfters 14 und der Kühlkassette 18 gekühlt wird, womit die Bearbeitung der betreffenden Baugruppe einschließlich des Verlötens abgeschlossen ist.

Bei dem vorstehend erwähnten Vorgang des Verlötens der Baugruppe 15 innerhalb des Druckgehäuses 19 ergeben sich die nachstehend anhand der Figuren 3a bis 3d dargestellten Bearbeitungsphasen. Gemäß Figur 3a ist die Baugruppe 15 über den Leiterzug 26 auf der Flachbaugruppe 15 positioniert, die die von den Transportbändern 1 bis 3 transportierten Baugruppen 15 darstellt. Der Leiterzug 26 trägt die auf ihn aufgebrachte Lötpaste 27, die sich bis zu dem anzulötendem Bauteil 28 erstreckt. Durch den oben im Zusammenhang mit der Figur 2 dargestellten Vorgang entsteht die in der Figur 3b dargestellte Verbindung von Leiterzug 26 und Bauteil 28, wobei die in der Figur 3b dargestellte Lötzone 29 mit den eingeschlossenen Lunkern 30 entsteht. Aufgrund des dabei auf die Anordnung wirkenden Überdrucks in dem Druckgehäuse 19 werden die Lunker, wie Figur 3c zeigt, hinsichtlich ihrer Ausmaße stark reduziert, enthalten jedoch in ihrem Innern das unter Druck stehende Druckgas. Wenn dann der Druck aus dem Druckgehäuse 19 abgeschaltet wird und atmosphärischer Druck in das Druckgehäuse 19 zurückkehrt, platzen die verbliebenen Lunker in der Lötzone 29 auf, womit sich eine geschlossene, lunkerfreie Lötzone ergibt, wie sie in der Figur 3 d dargestellt ist.

In der Figur 4a ist eine Vorrichtung dargestellt, die im Prinzip mit der Vorrichtung gemäß Figur 1 zusammen wirken kann, wobei jedoch die Lötstufe anders ausgebildet ist als in Figur 1 dargestellt, nämlich als quer zur Bewegungsrichtung der Transportbänder 1, 2 und 3 bewegbares Druckgehäuse 31. Das Druckgehäuse 31 ist in der Figur 4b in der Bearbeitungsposition dargestellt, in der es von der Seite her über das Transportband 1 (15 in Figur 2) geschoben ist, dieses in sich aufnimmt, wie dies die Figur 2 zeigt, wobei wie im Falle des Druckgehäuses 19 gemäß Figur 2 ein geschlossener Heiz- und Druckraum gebildet ist, in den von der Pumpe 25 her Druckgas gepumpt wird und in dem dann der Lötvorgang vor sich geht. Das Druckgehäuse 31 dichtet dabei mit seiner Stirnseite 33 gegenüber der Wandung des Gehäuses 34 ab und bildet damit eine abgeschottete Kammer. Bei der Anordnung gemäß Figur 4 a und b handelt es sich also lediglich um eine Variante hinsichtlich der Gestaltung und Bewegung des Druckgehäuses 19, womit dargelegt werden soll, dass das erfindungsgemäße Verfahren des Aufschmelzens der Lötpaste unter erhöhtem Druck und der danach erfolgten Absenkung des Drucks in dem Druckgehäuse jeweils in gleicher Weise vor sich gehen kann.

## Patentansprüche

1. Verfahren zum Reflow-Löten von mit Lötpaste versehenen Baugruppen (15) in einer abgeschotteten Kammer unter Beheizung in der Kammer (19), **dadurch gekennzeichnet, dass** in einem ersten Verfahrensschritt der Druck in der Kammer (19) gegenüber dem atmosphärischen Druck verstärkt und die Temperatur in der Kammer (19) durch Konvektionsheizung zum Schmelzen der Lötpaste erhöht wird und in einem zweiten Verfahrensschritt der Druck gesteuert auf atmosphärischen Druck unter Aufrechterhaltung der Temperatur wieder abgesenkt wird.

2. Verfahren zum Reflow-Löten nach Anspruch 1, **dadurch gekennzeichnet, dass** der Druckverstärkung eine abwechselnde Druckänderung überlagert ist.

3. Verfahren zum Reflow-Löten nach Anspruch 1, **dadurch gekennzeichnet, dass** der Druckabsenkung eine abwechselnde Druckänderung überlagert ist.

4. Verfahren zum Reflow-Löten nach Anspruch 1, **dadurch gekennzeichnet, dass** sowohl der Druckverstärkung als auch der Druckabsenkung eine abwechselnde Druckänderung überlagert ist.

5. Vorrichtung zur Durchführung des Verfahrens nach einem der Ansprüche 1 bis 4, **dadurch gekennzeichnet, dass** die Kammer durch ein Druckgehäuse (19, 31) gebildet ist, das durch Verschiebung in eine eine Baugruppe (15) einschließende Lage bringbar und an eine Druckgasleitung (24, 32) angeschlossen ist.
